(19) Europäisches Patentamt
European Patent Office
Office européen des brevets

(11) **EP 2 312 758 A1**

(12) **EUROPEAN PATENT APPLICATION**
published in accordance with Art. 153(4) EPC

(43) Date of publication:
**20.04.2011 Bulletin 2011/16**

(21) Application number: **08792229.0**

(22) Date of filing: **05.08.2008**

(51) Int Cl.:
**H04B 1/04** $^{(2006.01)}$

(86) International application number:
**PCT/JP2008/064062**

(87) International publication number:
**WO 2010/016111 (11.02.2010 Gazette 2010/06)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Fujitsu Limited**
**Kawasaki-shi, Kanagawa 211-8588 (JP)**

(72) Inventors:
• **TSUCHIYA, Toshikazu**
**Kawasaki-shi**
**Kanagawa 211-8588 (JP)**

• **SUZUKI, Kenji**
**Kawasaki-shi**
**Kanagawa 211-8588 (JP)**
• **SATOU, Michiko**
**Kawasaki-shi**
**Kanagawa 211-8588 (JP)**
• **TOYOMANE, Akira**
**Kawasaki-shi**
**Kanagawa 211-8588 (JP)**

(74) Representative: **Stebbing, Timothy Charles**
**Haseltine Lake LLP**
**Lincoln House, 5th Floor**
**300 High Holborn**
**London WC1V 7JH (GB)**

(54) **TRANSMISSION DEVICE AND ADJUSTMENT VALUE MEASUREMENT METHOD**

(57) An object is to shorten the time from when adjustment on each component to be adjusted is started until distortion compensation on a power amplifier is made optimum. To achieve the objective, adjustment values each for selecting the optimum filter coefficient corresponding to a transmission condition are obtained beforehand for transmission conditions, respectively. Under a transmission condition, an adjustment value corresponding to the transmission condition is given as an initial value to a processor that selects a filter coefficient. Accordingly, because adjustment of the filter coefficient is started from the optimum part, even when restarting transmission under a changed transmission condition, the transmission apparatus can shorten the time from when adjustment on each component to be adjusted is started until distortion compensation on the power amplifier is made optimum.

FIG.1

**Description**

TECHNICAL FIELD

The present invention relates to a transmission apparatus that performs distortion compensation on a power amplifier using a distortion compensator including an adaptive equalizer and relates to an adjustment value measurement method of measuring, in the transmission apparatus, an adjustment value that is used for selecting a filter coefficient that is set in a digital filter of the adaptive equalizer, which is a part of the distortion compensator. Particularly, the present invention relates to a transmission apparatus and an adjustment value measuring method that can shorten the time from when adjustment on each component to be adjusted in each unit is started until distortion compensation on the power amplifier is made optimum.

BACKGROUND ART

Conventional transmission apparatuses, such as base stations, in mobile communication systems may perform distortion compensation on non-linear properties of a power amplifier that amplifies transmission signal. As processors that perform distortion compensation, adaptive distortion compensators are well known that compare an output (reference signal) of a transmission signal generator of a transmission apparatus with a feedback signal fed back from the power amplifier and that perform a distortion compensation using an adaptive distortion compensation algorithm. Furthermore, adaptive equalizers are well known that adaptively equalize frequency characteristics of an analog circuit in order not to lower the effects of the distortion compensation by the adaptive distortion compensator.

When performing a distortion compensation using an adaptive distortion compensator or an adaptive equalizer, in order to compare a reference signal and a feedback signal, a transmission apparatus makes various adjustments, such as a delay adjustment for adjusting the timing of a feedback signal and an equalizer adjustment for compensating for the amplitude difference of a transmission signal.

Patent Document 1: Japanese Laid-open Patent Publication No. 2003-298362

DISCLOSURE OF INVENTION

PROBLEM TO BE SOLVED BY THE INVENTION

However, the components to be adjusted are related to each other and thus the transmission apparatus needs to gradually adjust each of components to be adjusted and adjust the components while checking how much both of the components are compensated. For example, according to the result of adjustment on one component to be adjusted, the transmission apparatus determines an adjustment amount for another component to be adjusted and then adjusts the other component to be adjusted. According to the result of adjustment on the other component to be adjusted, the transmission apparatus then determines an amount of adjustment for the component to be adjusted and again adjusts the component to be adjusted again. This leads to a problem that the transmission apparatus takes time from when adjustment on each component to be adjusted is started until distortion compensation of the power amplifier becomes optimum. Thus, there is an object to shorten the time from when adjustment on each component to be adjusted is started until distortion compensation of the power amplifier becomes optimum.

The disclosed technology has been developed in order to solve the above-described problem in the conventional technology. An object of the present invention is to provide a transmission apparatus that can shorten the time from when adjustment on each component to be adjusted is started until distortion compensation on a power amplifier is made optimum and to provide an adjustment value measurement method of measuring, in the transmission apparatus, an adjustment value that is used for selecting a filter coefficient that is set in a digital filter of an adaptive equalizer, which is a part of a distortion compensator.

MEANS FOR SOLVING PROBLEM

To solve the above-described problem and achieve the object, a transmission apparatus performs distortion compensation on a power amplifier using a distortion compensator that includes an adaptive equalizer, and requires a filter coefficient storage unit that stores filter coefficients that are each set in a digital filter of the adaptive equalizer; a filter coefficient setting unit that adaptively selects a filter coefficient from the filter coefficient storage unit according to a feedback signal from the power amplifier; an adjustment value storage unit that stores adjustment values in association with transmission frequencies, the adjustment values each being used by the filter coefficient setting unit to select the filter coefficient; and an initial value setting unit that reads an adjustment value corresponding to a transmission frequency, which is set in the transmission apparatus, from the adjustment value storage unit and sets the read adjustment value as an initial value of the adjustment value used for selecting the filter coefficient.

An adjustment value measurement method of measuring, in a transmission apparatus that includes a distortion compensator that performs distortion compensation on a power amplifier, an adjustment value that is used for selecting a filter coefficient set in a digital filter of an adaptive equalizer, which is a part of the distortion compensator, requires a distortion compensation stopping step of stopping the distortion compensation on the power amplifier; a transmission frequency setting step of setting multiple different transmission frequencies in the transmission apparatus; and a calculation step of calculating a variation amount of an output power of the power amplifier for each of the transmission frequencies that are set in the transmission frequency setting step.

EFFECT OF THE INVENTION

According to these aspects, the time from when adjustment on each component to be adjusted is started until distortion compensation on a power amplifier is made optimum can be shortened.

BRIEF DESCRIPTION OF DRAWINGS

FIG. 1 is a diagram illustrating an overview of a transmission apparatus.
FIG. 2 is a block diagram of a configuration of a transmission apparatus 1000.
FIG. 3 is a table of a specific example of an adjustment value selection table 1317.
FIG. 4 is a graph for explaining a method of calculating an approximate value of an adjustment value.
FIG. 5 is a graph illustrating a distortion compensation process of an adaptive equalizer 1304.
FIG. 6 is a diagram illustrating the distortion compensation process of the adaptive equalizer 1304.
FIG. 7 is a flowchart of a flow of processes performed by an initial value measurement processor 1314.
FIG. 8 is a flowchart of a flow of processes performed by an initial value setting unit 1318.

EXPLANATIONS OF LETTERS OR NUMERALS

1000    Transmission apparatus

1100    Transmission signal generator

1200    Transmission frequency receiver

1300    Transmission amplifying device

1301    Adaptive distortion compensator

1302    Multiplier

1303    Adaptive distortion compensation algorithm processor

1304    Adaptive equalizer

1305    Digital filter

1306    Adaptive equalization processor

1307    Filter coefficient group storage unit

1308    D/A converter

1309    Quadrature modulator

1310    Power amplifier

1311 Quadrature detector

1312 A/D converter

1313 Transmission frequency setting information

1314 Initial value measurement processor

1315 Reference carrier wave generator

1316 Feedback power detector

1317 Adjustment value selection table

1318 Initial value setting unit

1400 Orientation coupler

1500 Antenna

BEST MODE(S) FOR CARRYING OUT THE INVENTION

Preferred embodiments of a transmission apparatus according to the preset invention and of an adjustment value measurement method according to the present invention of measuring, in the transmission apparatus, an adjustment value used for selecting a filter coefficient that is set in a digital filter of an adaptive equalizer, which is a part of a distortion compensator, will be described in detail below with reference to the accompanying drawings. Embodiment

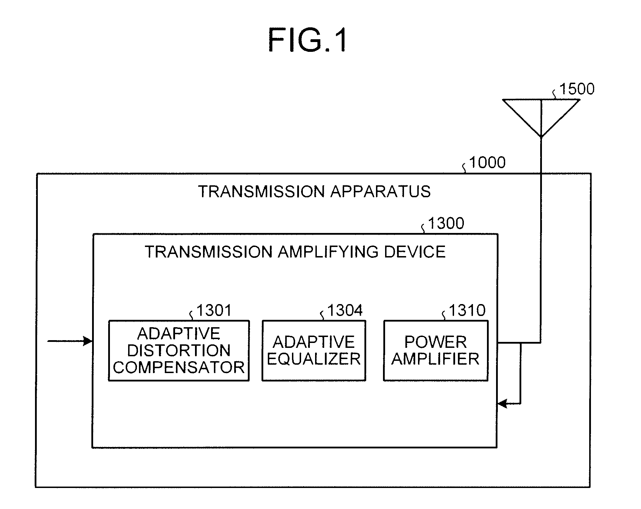

An overview of a transmission apparatus according to an embodiment will be described using FIG. 1. As illustrated in FIG. 1, a transmission apparatus 1000 inputs a transmission signal that the transmission apparatus 1000 generates to a transmission amplifying device 1300. After the transmission signal is amplified by the transmission amplifying device 1300, the amplified signal is output as a radio signal from an antenna 1500.

The transmission apparatus 1000 outputs the amplified transmission signal as a radio signal from the antenna 1500 and feeds back a feedback signal to the transmission amplifying device 1300. The transmission amplifying device 1300 performs a distortion compensation on a power amplifier 1310 according to the feedback signal. Specifically, the transmission amplifying device 1300 includes an adaptive distortion compensator 1301 and an adaptive equalizer 1304 and performs distortion compensations different from each other using those respective units. The transmission amplifying device 1300 uses a coefficient that is referred to as a distortion compensation coefficient for distortion compensation by the adaptive distortion compensator 1301 and uses a coefficient that is referred to as a filter coefficient for distortion compensation by the adaptive equalizer 1304. The distortion compensations that are respectively performed by those units are influenced by each other. For this reason, the transmission amplifying device 1300 gradually adjusts the coefficients in a way that the filter coefficient is adjusted, then the distortion compensation coefficient is adjusted, and then the filter coefficient is adjusted again. In this manner, the distortion compensation on the power amplifier 1310 is made optimum.

In a conventional transmission apparatus, however, even if the distortion compensation on a power amplifier is made optimum, when restarting transmission under a changed transmission condition, it is necessary to adjust a coefficient of each unit until the distortion compensation on the power amplifier becomes optimum, which takes time until the distortion compensation is made optimum again. For this reason, the transmission apparatus 1000 according to the embodiment obtains beforehand adjustment values for selecting the optimum filter coefficients corresponding to transmission conditions. When a transmission condition is applied, the transmission apparatus 1000 sends, as an initial value, an adjustment value corresponding to the transmission condition to a processor that selects a filter coefficient. Accordingly, an adjustment on the filter coefficient is started from the optimum part; therefore, even when transmission is restarted under a changed transmission condition, the transmission apparatus 1000 can shorten the time from when adjustment on each component to be adjusted is started until distortion compensation on the power amplifier is made optimum.

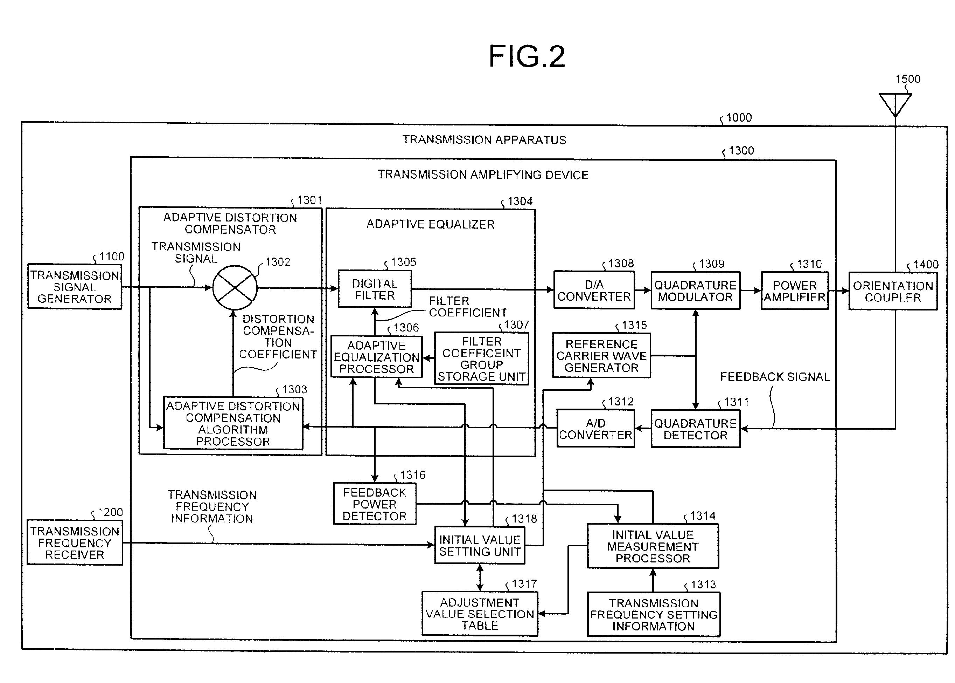

A configuration of the transmission apparatus 1000 will be described using FIG. 2. FIG. 2 is a block diagram of the configuration of the transmission apparatus 1000. As illustrated in FIG. 2, the transmission apparatus 1000 includes a transmission signal generator 1100, a transmission frequency receiver 1200, the transmission amplifying device 1300, an orientation coupler 1400, and the antenna 1500. The transmission amplifying device 1300 includes the adaptive distortion compensator 1301, a multiplier 1302, an adaptive distortion compensation algorithm processor 1303, the adaptive equalizer 1304, a digital filter 1305, an adaptive equalization processor 1306, a filter coefficient group storage unit 1307, a D/A converter 1308, a quadrature modulator 1309, the power amplifier 1310, a quadrature detector 1311, an A/D converter 1312, a transmission frequency setting information 1313, an initial value measurement processor 1314, a reference carrier wave generator 1315, a feedback power detector 1316, an adjustment value selection table 1317, and an initial value setting unit 1318.

The transmission signal generator 1100 outputs a row of digital data as a transmission signal. The transmission frequency receiver 1200 receives a change of the transmission condition for the transmission apparatus 1000 and outputs transmission frequency information on a setting of the transmission frequency.

The adaptive distortion compensator 1301 includes the multiplier 1302 and the adaptive distortion compensation algorithm processor 1303. The multiplier 1302 outputs a signal obtained by multiplying the transmission signal from the transmission signal generator 1100 by a distortion compensation coefficient that is input from the adaptive distortion compensation algorithm processor 1303. The adaptive distortion compensation algorithm processor 1303 performs an arithmetic operation and thus obtains a distortion compensation coefficient for compensating for the non-linear properties of the power amplifier 1310, using an adaptive algorithm, according to the transmission signal from the transmission signal generator 1100 and the feedback signal that is fed back from the power amplifier 1310 that is described below. The adaptive distortion compensation algorithm processor 1303 then outputs the distortion compensation coefficient, which is the result of the arithmetic operation, to the multiplier 1302.

The adaptive equalizer 1304 includes the digital filter 1305, the adaptive equalization processor 1306, and the filter coefficient group storage unit 1307. The signal that is output from the multiplier 1302 is input to the digital filter 1305. The digital filter 1305 then performs a predetermined filter process on the input signal and outputs the signal. The adaptive equalization processor 1306 regards, as an initial value, an adjustment value that is set by the initial value setting unit 1318 that is described below, selects a filter coefficient corresponding to the set adjustment value from the group of filter coefficients stored in the filter coefficient group storage unit 1307, and sets the selected filter coefficient in the digital filter 1305. After setting the filter coefficient in the digital filter 1305, the adaptive equalization processor 1306 obtains an out-of-band radiated power according to the feedback signal from the power amplifier 1310 and adjusts the adjustment value such that the out-of-band radiated power is minimum. The adaptive equalization processor 1306 then selects a filter coefficient corresponding to the adjusted adjustment value from the filter coefficient group storage unit 1307 and sets the selected filter coefficient in the digital filter 1305 again.

The D/A converter 1308 performs a digital/analog conversion on the output digital signal from the digital filter 1305 and then outputs the resulting signal to the quadrature modulator 1309. The quadrature modulator 1309 performs quadrature modulation by multiplying the output signal from the D/A converter 1308 by an output of the reference carrier wave generator 1315 and then outputs the resulting signal to the power amplifier 1310.

The power amplifier 1310 performs power amplification for the radio frequency signal obtained by the quadrature modulation and outputs the amplified radio frequency signal. The orientation coupler 1400 outputs the output signal from the power amplifier 1310 to the antenna 1500 and feeds back a feedback signal of the output signal. The feedback signal, which is fed back by the orientation coupler 1400, passes through the quadrature detector 1311, is converted by the A/D converter 1312 to a digital signal, and then is input to the adaptive distortion compensator 1301 and the adaptive equalizer 1304.

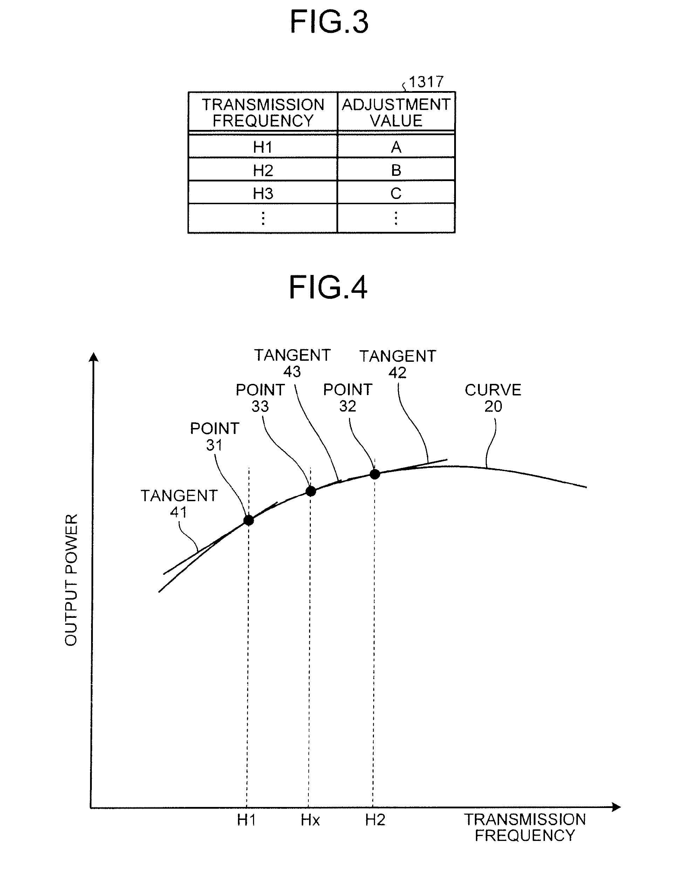

As illustrated in FIG. 3, the adjustment value selection table 1317 is a table in which combinations of adjustment values and transmission frequencies are registered. The adjustment value is used by the adaptive equalization processor 1306 of the adaptive equalizer 1304 to determine a filter coefficient. A transmission frequency is a frequency of a carrier wave that is generated by the reference carrier wave generator 1315.
The adjustment value selection table 1317 may be a table in which combinations of adjustment values and transmission frequencies are registered according to power amplifiers different from each other. Each power amplifier has different frequency characteristics. Thus, compared to a case in which a table that stores such combinations with respect to one power amplifier, in the case in which the above-described table is stored, it is possible to prevent the time required for a distortion compensation from varying depending on each power amplifier.

The initial value setting unit 1318 sets, in the adaptive equalization processor 1306 of the adaptive equalizer 1304, the initial value of the adjustment value for determining a filter coefficient of the digital filter 1305. Specifically, upon acquiring the transmission frequency information that is received by the transmission frequency receiver, the initial value setting unit 1318 searches for and reads the adjustment value corresponding to the newly-set transmission frequency and the adjustment value corresponding to the previously-set transmission frequency from the adjustment value selection table 1317. When there is no corresponding adjustment value in the adjustment value selection table 1317, the initial value setting unit 1318 obtains an approximate value of the adjustment value corresponding to the transmission frequency. The calculation method will be described below.

As illustrated in FIG. 4, the combination of the gradient of the tangent 41 and the transmission frequency at the point 31 of the curve 20 corresponds to the combination of the adjustment value "A" and the transmission frequency "H1" in the adjustment value selection table 1317 in FIG. 3. The combination of the gradient of the tangent 42 and the transmission frequency at the point 32 of the curve 20 corresponds to the combination of the adjustment value "B" and the transmission frequency "H2" in the adjustment value selection table 1317 in FIG. 3.

When the initial value setting unit 1318 searches for, from the adjustment value selection table 1317, an adjustment value corresponding to a transmission frequency "Hx" larger than the transmission frequency "H1" and smaller than the transmission frequency "H2", because no corresponding adjustment value is in the adjustment value selection table 1317, the initial value setting unit 1318 reads the transmission frequency "H1" smaller than the transmission frequency "Hx" and most close to the transmission frequency "Hx", the adjustment value "A" corresponding to the transmission frequency "H1", the transmission frequency "H2" larger than the transmission frequency "Hx" and most close to the transmission frequency "Hx", and the adjustment value "B" corresponding to the transmission frequency "H2".

The initial value setting unit 1318 calculates an adjustment value corresponding to the transmission frequency "Hx" according to the following Expression (1). The calculated adjustment value is an approximate of the gradient of the tangent 43 at the point 33 of the curve 20 in FIG. 4.

$$A + \frac{Fx - Fa}{Fb - Fa} \times (B - A) \qquad (1)$$

As described above, when the transmission frequency of the transmission apparatus 1000 is changed and an initial value of the adjustment value is set in the adaptive equalization processor 1306, even if no adjustment value corresponding to the transmission frequency is registered in the adjustment value selection table 1317, the initial value setting unit 1318 calculates a proximate of the corresponding adjustment value. This reduces the number of combinations of adjustment values and transmission frequencies that are registered in the adjustment value selection table 1317, which shortens the time taken by the initial value measurement processor 1314 to generate the adjustment value selection table 1317.

The initial value setting unit 1318 subtracts the adjustment value corresponding to the previously-set transmission frequency from the adjustment value corresponding to the currently-set transmission frequency. The initial value setting unit 1318 reads the convergence value of the adjustment value, which is used by the adaptive equalization processor 1306 to determine the current filter coefficient, from the adaptive equalization processor 1306 and adds the convergence value to result of the subtraction. The initial value setting unit 1318 then sets the result of the adding in the adaptive equalization processor 1306. The convergence value that is read from the adaptive equalization processor 1306 is the value that reflects the influence of the current temperature and age-related changes and that is optimum to the power amplifier 1310. By adding the difference between adjustment values that is read from the adjustment value selection table 1317 or calculated to the adjustment value, the optimum adjustment value containing temperature variations and age-related changes can be set as the initial value. In addition, because the initial value setting by the initial value setting unit 1318 allows the adaptive equalization processor 1306 of the adaptive equalizer 1304 to start adjusting the filter coefficient from the optimum part, even when transmission is restarted under a changed transmission condition, the transmission amplifier 100 can shorten the time from when adjustment of each component to be adjusted is started until the distortion compensation on the power amplifier is made optimum.

Each unit and information related to the adjustment value measurement method in the transmission amplifying device 1300 will be described below. For example, each unit operates during a factory test of the transmission apparatus 1000. The transmission frequency setting information 1313 is control information for the initial value measurement processor 1314 to set multiple different frequencies for the reference carrier wave generator 1315.

The initial value measurement processor 1314 measures frequency characteristics of the adjustment value that is the value used by the adaptive equalization processor 1306 of the adaptive equalizer 1304 to determine the filter coefficient and registers combinations of adjustment valued and transmission frequencies in the adjustment value selection table 1317.

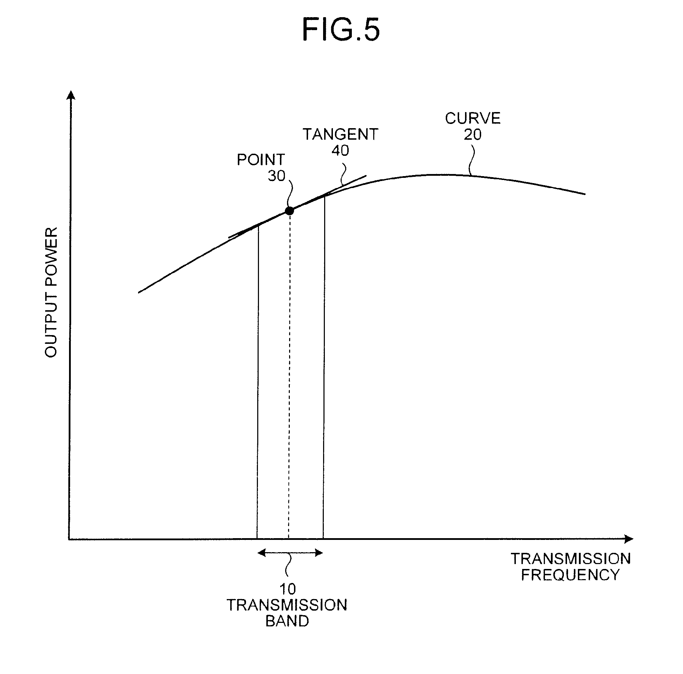

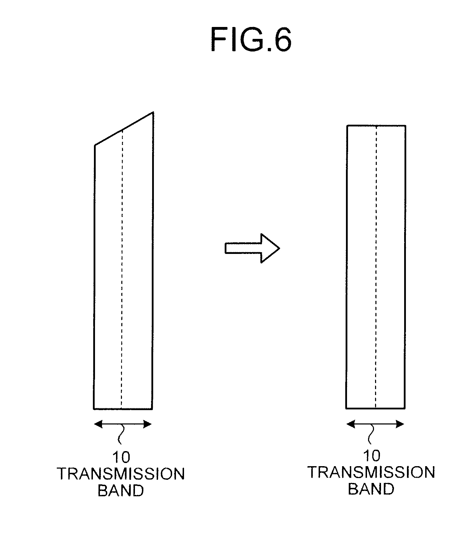

A distortion compensation process of the adaptive equalizer will be described below using FIGS. 5 and 6. FIG. 5 is a graph illustrating the frequency characteristics of the output power of the power amplifier 1310. As indicated by the curve 20 in FIG. 5, the value of the output power of the power amplifier 1310 differs according to each transmission frequency. Regarding the frequency characteristics of the output power of the power amplifier 1310, as illustrated in FIG. 6, the adaptive equalizer 1304 corrects the frequency characteristics of the output power of the power amplifier 1310 to be flat such that the output power becomes the same value with any transmission frequency in the transmission band 10. In other words, the adaptive equalization processor 1306 of the adaptive equalizer 1304 selects a filter coefficient corresponding to the gradient of the tangent 40 at the point 30 on the curve 20 from the filter coefficient group storage unit 1307 and sets the selected filter coefficient in the digital filter 1305.

The initial value measurement processor 1314 beforehand obtains gradients of tangents at some points on the curve 20 as adjustment values and registers combinations of adjusted values and transmission frequencies in the adjustment value selection table 1317. Specifically, in order to measure the characteristics of the power amplifier 1310, the initial value measurement processor 1314 initializes the distortion compensation coefficient that is output to the multiplier 1302 and the filter coefficient that is set in the digital filter 1305, thereby realizing a state in which a distortion compensation is not performed on the power amplifier 1310.

The initial value measurement processor 1314 reads the transmission frequency setting information 1313, instructs the reference carrier wave generator 1315 to output a carrier wave at a predetermined frequency, and then instructs the reference carrier wave generator 1315 to output a carrier wave at a frequency shifted by a small value from the predetermined frequency.

The initial value measurement processor 1314 is notified by the feedback power detector 1316, which is described below, of the value of the output power of the power amplifier 1310 for the carrier wave of the predetermined frequency and of the value of the output power of the power amplifier 1310 for the carrier wave at the frequency that is slightly shifted by the small value from the predetermined frequency.

By dividing the difference of the output power, which is notified by the feedback power detector 1316, by the value by which the frequency of the carrier wave is shifted, the initial value measurement processor 1314 obtains the variation amount of the output power of the power amplifier at the predetermined transmission frequency.

The initial value measurement processor 1314 similarly obtains the variation amounts of the output power of the power amplifier 1310 at other different transmission frequencies according to the transmission frequency setting information 1313. The initial value measurement processor 1314 regards the obtained variation amounts of the output power of the power amplifier 1310 as adjustment values and registers the adjustment values in combination with the transmission frequencies in the adjustment value selection table 1317. The procedure of the process of the initial value measurement processor 1314 for calculating the variation amount of the output power may be performed in any order as long as the gradient of the tangent at each point on the curve 20 can be obtained.

The feedback power detector 1316 measures the output power of the power amplifier 1310 according to the feedback signal from the power amplifier 1310 and notifies the initial value measurement processor 1314 of the result of the measurement.

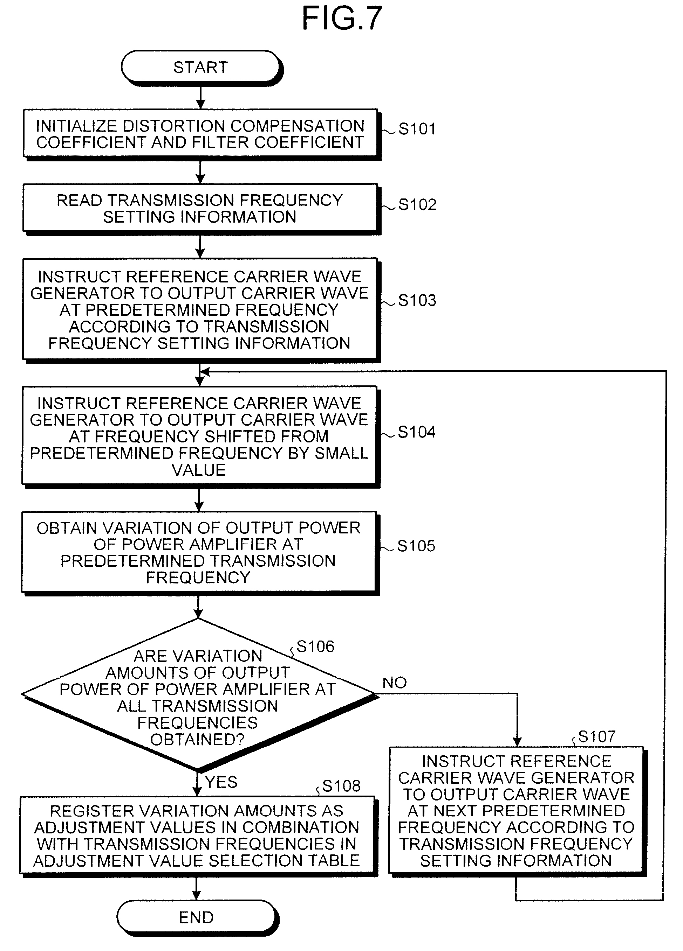

A flow of processes of the initial value measurement processor 1314 will be described below, using the flowchart of FIG. 7. FIG. 7 is a flowchart of the flow of the processes performed by the initial value measurement processor 1314. The process flow illustrated in FIG. 7 is performed when adjusting the transmission apparatus 1000 during a factory test.

In order to realize the sate in which no distortion compensation is performed on the power amplifier 1310, first, the initial value measurement processor 1314 initializes the distortion coefficient and the filter coefficient (step S101) and the initial value measurement processor 1314 reads the transmission frequency setting information (step S102).

The initial value measurement processor 1314 instructs the reference carrier wave generator 1315 to output a carrier wave at the predetermined frequency according to the read transmission frequency setting information 1313 (step S103). The initial value measurement processor 1314 instructs the reference carrier wave generator 1315 to output a carrier wave at a frequency of a value slightly shifted from the predetermined frequency by a small value (step S104).

The initial value measurement processor 1314 is notified by the feedback power detector 1316 of the output power of the power amplifier 1310 and thus the initial value measurement processor 1314 obtains the variation amount of the output power of the power amplifier 1310 at the predetermined transmission frequency (step S105). Once the initial value measurement processor 1314 obtains the variation amounts of the output power of the power amplifier 1310 at all the transmission frequencies according to the transmission frequency setting information 1313 (YES at step S106), the initial value measurement processor 1314 registers the variation amounts of the output power as adjustment values in combination with the transmission frequencies in the adjustment value selection table 1317 (step S108) and completes the process.

In contrast, when the variation amounts of the output power of the power amplifier 1310 at not all the transmission frequencies according to the transmission frequency setting information 1313 are obtained (NO at step S106), the initial value measurement processor 1314 instructs the reference carrier wave generator 1315 to output a carrier wave at the next predetermined frequency according to the transmission frequency setting information 1313 (step S107) and returns to the process at step S104.

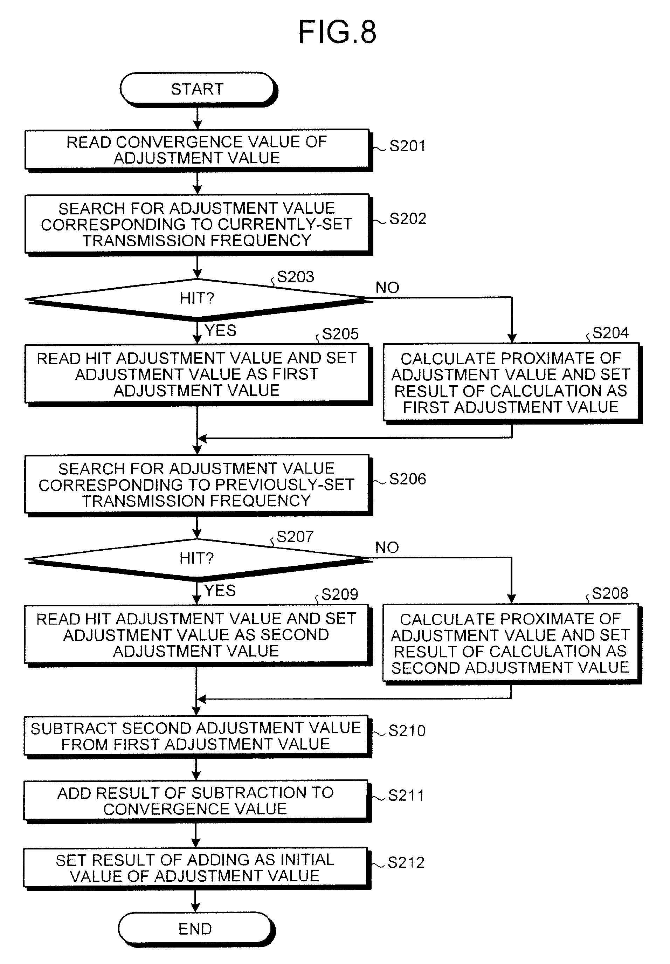

A flow of processes performed by the initial value setting unit 1318 will be described below using the flowchart of FIG. 8. FIG. 8 is a flowchart of the flow of the processes performed by the initial value setting unit 1318. The process flow in FIG. 8 is repeatedly performed each time a transmission frequency that is different from the currently-set transmission frequency in the transmission apparatus 1000 is set.

First, the initial value setting unit 1318 reads the convergence value of the adjustment value, which is a value used by the adaptive equalization processor 1306 to determined a filter coefficient, from the adaptive equalization processor 1306 (step S201). The initial value setting unit 1318 searches for an adjustment value corresponding to the currently-set transmission frequency from the adjustment value selection table 1317 (step S202). As a result of the search, when the corresponding adjustment value is in the adjustment value selection table 1317 (YES at step S203), the initial value setting unit 1318 reads the adjustment value and sets the adjustment value as a first adjustment value (step S205). In contrast, as a result of the search, when there is no corresponding adjustment value in the adjustment value selection table 1317 (NO at step S203), the initial value setting unit 1318 calculates a proximate of the adjustment value and sets the result of the calculation as the first adjustment value (step S204).

The initial value setting unit 1318 then searches for the adjustment value corresponding to the previously-set transmission frequency from the adjustment value selection table 1317 (step S206). As a result of the search, when the corresponding adjustment value is in the adjustment value selection table 1317 (YES at step S207), the initial value setting unit 1318 reads the adjustment value and sets the adjustment value as a second adjustment value (step S209). In contrast, when no corresponding adjustment value is in the adjustment value selection table 1317 (NO at step S207), the initial value setting unit 1318 calculates a proximate of the adjustment value and sets the result of the calculation as the second adjustment value (step S208).

The initial value setting unit 1318 subtracts the second adjustment value from the first adjustment value (step S210) and adds the result of the subtraction to the convergence value that is read from the adaptive equalization processor 1306 at step S201 (step S211). The initial value setting unit 1318 sets the result of the adding as the initial value of the adjustment value of the adaptive equalization processor 1306 (step S212) and completes the process.

As described above, the transmission apparatus 1000 according to the embodiment stores the adjustment value selection table 1317 in which combinations of adjustment values and transmission frequencies are registered. When the transmission frequency is changed, the initial value setting unit 1318 reads the adjustment value corresponding to the transmission frequency from the adjustment value selection table 1317 and sets, in the adaptive equalization processor 1306, the read adjustment value as the initial value of the adjustment value for determining the filter coefficient of the digital filter 105. Accordingly, adjustment of the filter coefficient of the digital filter 1305 is started from the optimum part; therefore, even when transmission is restarted under a changed transmission condition, the transmission apparatus 1000 can shorten the time from when each adjustment is started until the distortion compensation on the power amplifier is made optimum.

In addition, by reading the convergence value of the adjustment value from the adaptive equalization processor 1306 and adding the difference between adjustment values, which are read from the adjustment value selection table 1317, to the adjustment value, the optimum adjustment value containing the temperature variations and the age-related changes can be set as the initial value.

Furthermore, because adjustment of the filter coefficient of the digital filter 1305 is started from the optimum part, significant deviation is not caused in the adjustment of the filter coefficient. Accordingly, it is possible to prevent that the adjustment of the filter coefficient has adverse effects on the calculation of other components to be adjusted and that, at the worst case, the feedback control on the distortion compensation becomes unstable.

When the transmission frequency of the transmission apparatus 1000 is changed and the initial value of the adjustment value is set for the adaptive equalization processor 1306, even when no adjustment value corresponding to the transmission frequency is registered in the adjustment value selection table 1317, the initial value setting unit 1318 calculates a proximate of the corresponding adjustment value. This reduces the number of combinations of adjustment values and transmission frequencies that are registered in the adjustment value selection table 1317, thereby shortening the time taken by the initial value measurement processor 1314 to generate the adjustment value selection table 1317.

**Claims**

1.  A transmission apparatus that performs distortion compensation on a power amplifier using a distortion compensator that includes an adaptive equalizer, the transmission apparatus comprising:

    a filter coefficient storage unit that stores filter coefficients that are each set in a digital filter of the adaptive equalizer;
    a filter coefficient setting unit that adaptively selects a filter coefficient from the filter coefficient storage unit according to a feedback signal from the power amplifier;
    an adjustment value storage unit that stores adjustment values in association with transmission frequencies, the adjustment values each being used by the filter coefficient setting unit to select the filter coefficient; and
    an initial value setting unit that reads an adjustment value corresponding to a transmission frequency, which is set in the transmission apparatus, from the adjustment value storage unit and sets the read adjustment value as an initial value of the adjustment value used for selecting the filter coefficient.

2.  The transmission apparatus according to claim 1, wherein the initial value setting unit reads, from the storage unit, a first adjustment value corresponding to a transmission frequency that is newly set and a second adjustment value corresponding to a transmission frequency that is previously set in the transmission apparatus, subtracts the second adjustment value from the first adjustment value, adds a result of the subtraction to an adjustment value that is currently used by the filter coefficient setting unit for selecting a filter coefficient, and sets a result of the adding as the initial value.

3. The transmission apparatus according to claim 1 or 2, wherein the initial value setting unit calculates a proximate of the adjustment value corresponding to the transmission frequency, which is set in the transmission apparatus, using information that is stored by the adjustment value storage unit.

4. The transmission apparatus according to claim 3, wherein the initial value setting unit reads, from the storage unit, a first transmission frequency, a first proximate adjustment value corresponding to the first transmission frequency, a second transmission frequency, and a second proximate adjustment value corresponding to the second transmission frequency, and calculates the adjustment value corresponding to the transmission frequency by adding the first proximate adjustment value to a value obtained by dividing a product of a difference between the set transmission frequency and the first transmission frequency and a difference between the second proximate adjustment value and the first proximate adjustment value by a difference between the second transmission frequency and the first transmission frequency.

5. The transmission apparatus according to claim 1, wherein the adjustment value storage unit stores the adjustment values associated with the transmission frequencies for each power amplifier.

6. An adjustment value measurement method of measuring, in a transmission apparatus that includes a distortion compensator that performs distortion compensation on a power amplifier, an adjustment value that is used for selecting a filter coefficient set in a digital filter of an adaptive equalizer, which is a part of the distortion compensator, the adjustment value measurement method comprising:

a distortion compensation stopping step of stopping the distortion compensation on the power amplifier;
a transmission frequency setting step of setting multiple different transmission frequencies in the transmission apparatus; and
a calculation step of calculating a variation amount of an output power of the power amplifier for each of the transmission frequencies that are set in the transmission frequency setting step.

# FIG.1

1500

1000

TRANSMISSION APPARATUS

1300

TRANSMISSION AMPLIFYING DEVICE

| 1301 | 1304 | 1310 |
|---|---|---|
| ADAPTIVE DISTORTION COMPENSATOR | ADAPTIVE EQUALIZER | POWER AMPLIFIER |

# FIG.2

TRANSMISSION APPARATUS 1000

TRANSMISSION AMPLIFYING DEVICE 1300

1500

ORIENTATION COUPLER 1400

POWER AMPLIFIER 1310

QUADRATURE MODULATOR 1309

D/A CONVERTER 1308

REFERENCE CARRIER WAVE GENERATOR 1315

QUADRATURE DETECTOR 1311

A/D CONVERTER 1312

FEEDBACK SIGNAL

INITIAL VALUE MEASUREMENT PROCESSOR 1314

TRANSMISSION FREQUENCY SETTING INFORMATION 1313

ADAPTIVE EQUALIZER 1304

FILTER COEFFICIENT

FILTER COEFFICIENT GROUP STORAGE UNIT 1307

DIGITAL FILTER 1305

ADAPTIVE EQUALIZATION PROCESSOR 1306

FEEDBACK POWER DETECTOR 1316

INITIAL VALUE SETTING UNIT 1318

ADJUSTMENT VALUE SELECTION TABLE 1317

ADAPTIVE DISTORTION COMPENSATOR 1301

TRANSMISSION SIGNAL 1302

DISTORTION COMPENSA-TION COEFFICIENT

ADAPTIVE DISTORTION COMPENSATION ALGORITHM PROCESSOR 1303

TRANSMISSION FREQUENCY INFORMATION

TRANSMISSION SIGNAL GENERATOR 1100

TRANSMISSION FREQUENCY RECEIVER 1200

# FIG.3

| TRANSMISSION FREQUENCY | ADJUSTMENT VALUE |
|:---:|:---:|
| H1 | A |
| H2 | B |
| H3 | C |
| ⋮ | ⋮ |

1317

# FIG.4

# FIG.5

# FIG.6

10
TRANSMISSION
BAND

10
TRANSMISSION
BAND

# FIG.7

```
                    START

INITIALIZE DISTORTION COMPENSATION        S101
COEFFICIENT AND FILTER COEFFICIENT

READ TRANSMISSION FREQUENCY               S102
SETTING INFORMATION

INSTRUCT REFERENCE CARRIER WAVE           S103
GENERATOR TO OUTPUT CARRIER WAVE
AT PREDETERMINED FREQUENCY
ACCORDING TO TRANSMISSION
FREQUENCY SETTING INFORMATION

INSTRUCT REFERENCE CARRIER WAVE           S104
GENERATOR TO OUTPUT CARRIER WAVE
AT FREQUENCY SHIFTED FROM
PREDETERMINED FREQUENCY BY SMALL
VALUE

OBTAIN VARIATION OF OUTPUT POWER          S105
OF POWER AMPLIFIER AT
PREDETERMINED TRANSMISSION
FREQUENCY

ARE VARIATION                             S106
AMOUNTS OF OUTPUT
POWER OF POWER AMPLIFIER AT    NO
ALL TRANSMISSION
FREQUENCIES
OBTAINED?

                YES                       S108

REGISTER VARIATION AMOUNTS AS             INSTRUCT REFERENCE         S107
ADJUSTMENT VALUES IN COMBINATION          CARRIER WAVE GENERATOR
WITH TRANSMISSION FREQUENCIES IN          TO OUTPUT CARRIER WAVE
ADJUSTMENT VALUE SELECTION TABLE          AT NEXT PREDETERMINED
                                          FREQUENCY ACCORDING TO
                END                       TRANSMISSION FREQUENCY
                                          SETTING INFORMATION
```

# FIG.8

START

READ CONVERGENCE VALUE OF
ADJUSTMENT VALUE ⟶ S201

SEARCH FOR ADJUSTMENT VALUE
CORRESPONDING TO CURRENTLY-SET
TRANSMISSION FREQUENCY ⟶ S202

S203
HIT? — NO

YES S205
READ HIT ADJUSTMENT VALUE AND SET
ADJUSTMENT VALUE AS FIRST
ADJUSTMENT VALUE

S204
CALCULATE PROXIMATE OF
ADJUSTMENT VALUE AND SET
RESULT OF CALCULATION AS
FIRST ADJUSTMENT VALUE

SEARCH FOR ADJUSTMENT VALUE
CORRESPONDING TO PREVIOUSLY-SET
TRANSMISSION FREQUENCY ⟶ S206

S207
HIT? — NO

YES S209
READ HIT ADJUSTMENT VALUE AND SET
ADJUSTMENT VALUE AS SECOND
ADJUSTMENT VALUE

S208
CALCULATE PROXIMATE OF
ADJUSTMENT VALUE AND SET
RESULT OF CALCULATION AS
SECOND ADJUSTMENT VALUE

SUBTRACT SECOND ADJUSTMENT VALUE
FROM FIRST ADJUSTMENT VALUE ⟶ S210

ADD RESULT OF SUBTRACTION TO
CONVERGENCE VALUE ⟶ S211

SET RESULT OF ADDING AS INITIAL
VALUE OF ADJUSTMENT VALUE ⟶ S212

END

<table>
<tr><td colspan="2" align="center"><b>INTERNATIONAL SEARCH REPORT</b></td><td>International application No.<br><br>PCT/JP2008/064062</td></tr>
</table>

A. CLASSIFICATION OF SUBJECT MATTER
*H04B1/04*(2006.01)i


According to International Patent Classification (IPC) or to both national classification and IPC

B. FIELDS SEARCHED

Minimum documentation searched (classification system followed by classification symbols)
H04B1/04



Documentation searched other than minimum documentation to the extent that such documents are included in the fields searched
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)



C. DOCUMENTS CONSIDERED TO BE RELEVANT

| Category* | Citation of document, with indication, where appropriate, of the relevant passages | Relevant to claim No. |
|---|---|---|
| X<br>A | JP 2005-244937 A (NTT Docomo Inc.),<br>08 September, 2005 (08.09.05),<br>Full text; all drawings<br>& US 2005/0162225 A1 & EP 1560327 A1<br>& DE 602005000014 D & KR 10-2005-0077788 A<br>& CN 1649258 A | 1,6<br>2-5 |
| A | JP 2005-73032 A (Hitachi Kokusai Electric Inc.),<br>17 March, 2005 (17.03.05),<br>Full text; all drawings<br>(Family: none) | 1-6 |
| A | JP 2003-298362 A (Fujitsu Ltd.),<br>17 October, 2003 (17.10.03),<br>Full text; all drawings<br>& US 2003/0184372 A1 | 1-6 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>25 September, 2008 (25.09.08) | Date of mailing of the international search report<br>07 October, 2008 (07.10.08) |
|---|---|
| Name and mailing address of the ISA/<br>Japanese Patent Office | Authorized officer |
| Facsimile No. | Telephone No. |

Form PCT/ISA/210 (second sheet) (April 2007)

**EP 2 312 758 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003298362 A